# EUROPEAN PATENT APPLICATION

(11) **EP 4 387 097 A1**
(43) Date of publication of application: **19.06.2024**
(21) Application number: 23211423.1
(22) Date of filing: 22.11.2023
(51) Int. Cl.: H03G 1/00, H03G 3/30, H03F 3/45, H03F 1/08, H03F 3/08, H03F 3/50

(54) **TIA WITH TUNABLE GAIN**

(30) Priority: 12.12.2022 US 202263431922 P
(71) Applicant: Nokia Solutions and Networks Oy, 02610 Espoo (FI)
(72) Inventor: IOTTI, Lorenzo, Brooklyn - NY 11211 (US); FERRISS, Mark, Tarrytown - NY 10591 (US); RYLYAKOV, Alexander, Staten Island - NY 10312 (US)
(74) Representative: Nokia EPO representatives

(57) **Abstract**

An apparatus, such as a coherent optical receiver, includes a TIA (400), the TIA (400) including a cascode circuit having a cascode node. A first tunable element (M1) is connected to tunably shunt the cascode node to vary a voltage gain of the TIA (400), e.g. up to a first amount. Implementations of the TIA (400) further include another tunable element (M2) connected to vary a load of the cascode circuit to vary the voltage gain, e.g. up to a second amount. A current steering circuit (441) may be provided to vary the voltage gain up to a third amount, each of the amounts being only a fraction of a target voltage gain variation of the TIA (400).

## Description

### FIELD

Various example embodiments relate to variable-gain trans-impedance amplifiers and coherent optical receivers with such trans-impedance amplifiers.

### BACKGROUND

Trans-impedance amplifiers (TIAs) are used in high speed fiber optic communication systems, to provide a link between optical-to-electrical converters, e.g. photo detectors (PD), and the downstream electronics of optical receivers, such as but not limited to coherent optical receivers. A TIA converts the current coming from the PD into a voltage, thus providing transimpedance gain (ZT). This voltage is typically fed to an Analog-to-Digital Converter (ADC), and the resulting signal may be processed in the digital domain. The TIA is desirably linear, and has a well-controlled gain in the relevant operating range, so that the ADC receives a voltage that is a linear representation of the current from the PD, and has a magnitude that matches the dynamic range of the ADC.

### SUMMARY

An aspect of the present disclosure provides an apparatus. First embodiments of the apparatus comprise a TIA circuit. The TIA circuit comprises a cascode circuit including a cascode node, and a first tunable element connected to tunably shunt the cascode node to vary a voltage gain of the TIA circuit.

In any of the first embodiments, the first tunable element may comprise a first transistor operable to vary an impedance of the cascode node by at most 6 dB. In some of such first embodiments, the first transistor may be operable to vary the impedance of the cascode node by at most 12 dB. In any of such first embodiments, the first tunable element may be a MOS transistor.

Any of the above first embodiments may further comprise a second tunable element connected to shunt a load resistor of the TIA circuit. In some of such first embodiments, each of the first and second tunable elements may be configured to reduce the gain of the TIA circuit by no more than 12dB.

In any of the first embodiments, the apparatus may comprise a coherent optical receiver including the TIA circuit.

Second embodiments of the apparatus comprise a TIA circuit, the TIA circuit comprising a VGA having a tunable internal AC shunt. In some of the second embodiments, the VGA comprises a cascode circuit including a cascode node, and the tunable internal AC shunt comprises a tunable element connected to variably shunt the cascode node. In any of the second embodiments, the apparatus may comprise a coherent optical receiver including the TIA circuit.

A related aspect of the present disclosure provides a method for controlling a TIA gain, comprising variably shunting a cascode node of the TIA. Some embodiments of the method further comprise at least one of: variably shunting a load resistor of the TIA, and steering a tunable fraction of a current flowing through the cascode node away from the load resistor.

In some embodiments of the above method, the variably shunting a load resistor of the TIA decreases the TIA voltage gain by a first amount, and at least one of: the variably shunting a cascode node of the TIA and the steering a tunable fraction of a current flowing through the cascode node further decreases the TIA voltage gain by a second amount additional to the first amount. In some of such embodiments of the above method, the variably shunting a cascode node of the TIA decreases the TIA voltage gain by up to the second amount additionally to the first amount, and the steering a tunable fraction of a current flowing through the cascode node away from the load resistor further decreases the TIA voltage gain by up to a third amount additionally to the first and second amounts.

### BRIEF DESCRIPTION OF THE DRAWINGS

Embodiments disclosed herein will be described in greater detail with reference to the accompanying drawings which represent preferred embodiments thereof, in which like elements are indicated with like reference numerals, and wherein:
FIG. 1 is a schematic block diagram of a coherent optical receiver where the TIA(s) of the present disclosure may be used;
FIG. 2 is a schematic block diagram of a TIA circuit that may be used in the coherent optical receiver of FIG. 1;
FIG. 3 shows a schematic circuit diagram of a variable-gain front-end TIA (FE-TIA) with shunt feedback;
FIG. 4 shows a circuit diagram of a core portion of the FE-TIA with three sub-circuits for tuning a gain of the FE-TIA, for use in the TIA of any of the circuits shown in FIGs. 1 to 3;
FIG. 5 is a schematic block diagram of a TIA gain control module for use in any of the circuits shown in FIGs. 1 to 4;
FIG. 6 shows an example circuit implementation of a tunable-gain TIA including the core portion illustrated in FIG. 4, for use in the TIA of any of the circuits shown in FIGs. 1 to 3.

### DESCRIPTION

In the following description, for purposes of explanation and not limitation, specific details are set forth, such as particular circuits, circuit components, techniques, etc. in order to provide a thorough understanding of the present invention. However, it will be apparent to one skilled in the art that the present invention may be practiced in other embodiments that depart from these specific details. In other instances, detailed descriptions of well-known methods, devices, and circuits may be omitted so as not to obscure the description of the present invention. All statements herein reciting principles, aspects, and embodiments of the invention, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Furthermore, the following abbreviations and acronyms may be used in the present document:
ADC: Analog-to-Digital Converter
AGC: Automatic Gain Control
AC: Alternating Current
ASIC: Application Specific Integrated Circuit
A0: voltage gain
BiCMOS: Bipolar Complementary Metal-Oxide-Seminconductor
BW: BandWidth
DC: Direct Current
DSP: Digital Signal Processor
FE-TIA: Front-End Trans-Impedance Amplifier
FET: Field Effect Transistor
LO: Local Oscillator
MOS: Metal-Oxide-Semiconductor
GBW: Gain BandWidth product
GDV: Group Delay Variation
RF: Feedback Resistance
TIA: Trans-Impedance Amplifier
VGA: Variable Gain Amplifier
ZIN: input impedance
ZT: transimpedance

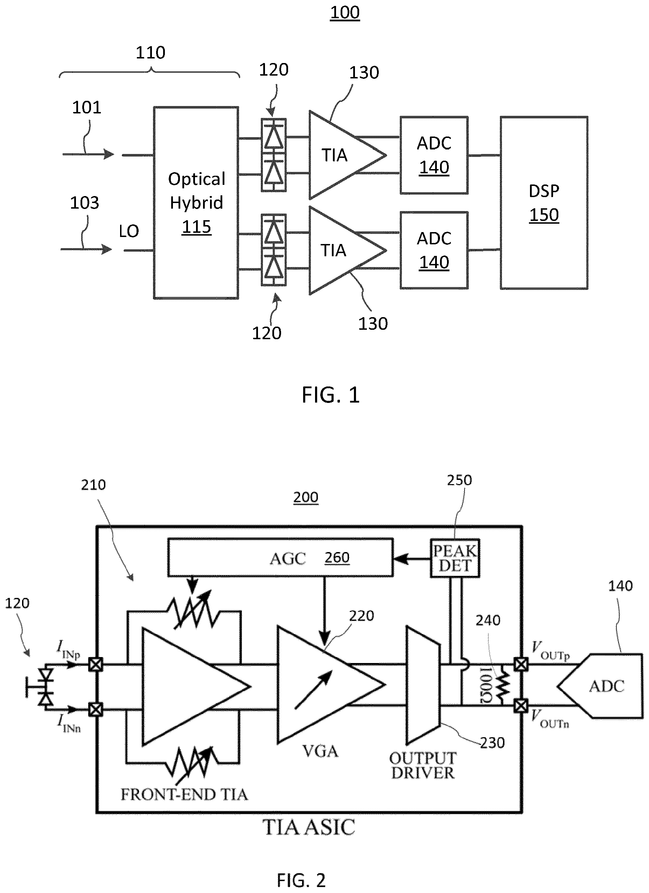

FIG. 1 illustrates a block diagram of an example coherent optical receiver 100 to which embodiments of the present disclosure may relate. An optical signal received from an optical communication link (not shown) is mixed with LO light in an optical hybrid 115. Different mixtures of the optical signal and LO light from four output ports of the optical hybrid 115 are transmitted to two photodiode (PD) pairs 120. Each PD pair 120 may be suitably biased at mid-point. The two PDs of a pair measure mixtures of the received optical signal light 101 with LO light 103 with different relative phase shifts. The signals from the two PDs of a pair are coupled to the differential inputs of a corresponding TIA circuit 130. Differential outputs of the TIAs 130 are provided to respective ADCs 140, which are, in turn, connected to a DSP 150 for signal processing and data de-modulation.

A block diagram of a typical TIA circuit 200, which may be implemented e.g. as an Application-Specific Integrated Circuit (ASIC), is shown in FIG. 2. It includes a front-end TIA 210 (FE-TIA), which converts input PD current(s) from a PD pair 120, e.g. *I*_{INP} and *I*_{Inn}, into a voltage signal, followed by a series of one or more Variable Gain Amplifiers (VGA) 220 to provide further voltage amplification, and an output driver 230. The output driver 230 is typically a transconductor, which drives an on-chip termination resistor 240 as well as being connected to the inputs of the ADC 140. The TIA circuit 200 may also include a peak detector 250 to measure the output swing, and an Automatic Gain Control (AGC) loop 260, which adjusts the TIA gain in order to keep the peak output swing at a desired value in the presence of slow variations of the swing of the currents *I*_{INP} and *I*_{Inn} input to the TIA 200.

For the coherent optical receiver illustrated in FIG. 1, the TIA input signal amplitude can vary suddenly by >10x (20dB) due to events in the optical network. Such events can substantially change the optical signal propagating to an optical receiver, at a rate much lower than the baud rate or symbol rate of the optical signal. In response to such events, gain of the TIA circuit may be adjusted by the AGC, so that the amplitude of the output signal, e.g. a differential output voltage Δ*V*_{OUT} = (*V*_{OUTp}- *V*_{OUTn}), remains about constant and within a desirable operating range of the ADC 140 that is connected to receive the output signals of the TIA circuit 200.

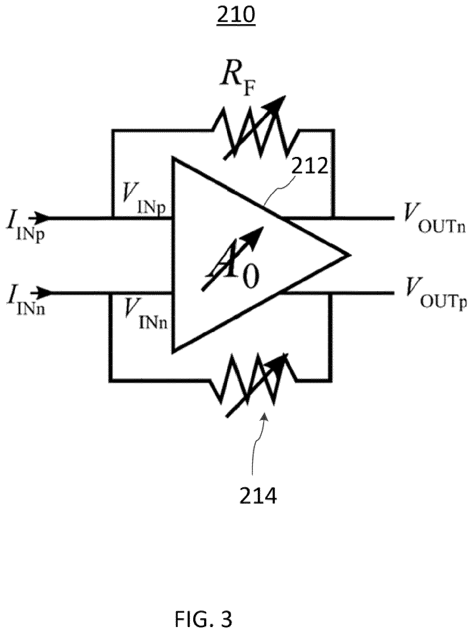

Referring to FIG. 3, FE-TIAs typically use a shunt-feedback topology, obtained by pairing a core amplifier 212 with a feedback resistor (R_{F}) 214. The feedback resistor 214 here may be a circuit that controls an electrical current flowing therethrough, and may include more than one element or device, e.g. one or more transistors. This "shunt-feedback" topology is known for its low noise performance, and thus is commonly used in high-performance transceivers. The input PD currents *I*_{INp} and *I*_{INn} create voltage signals V_{INp} and V_{INn} at the inputs of the core amplifier 212, which is schematically shown as an operational amplifier. The transimpedance ZT of the shunt-feedback FE-TIA 210 is roughly equivalent to the value of the shunt resistor 214 R_{F}, so a variable-gain TIA can be easily obtained using a variable feedback resistor 214. However, the TIA input impedance Z_{IN} is approximately given by a ratio R_{F}/A₀, Z_{IN} ~ R_{F}/A₀, where A₀ is the voltage gain of the core amplifier 212 of the FE-TIA 210. Here, the voltage gain A₀ refers to the ratio, typically measured in dB, of the differential output voltage ΔV_{OUT} = (V_{OUTp} - V_{OUTn}) to the differential input voltage ΔV_{IN} = (V_{INp} - V_{INn}) of the core amplifier 212 of the FE-TIA 210.

Therefore, a variation of a resistance value R_{F} of the feedback resistor 214 produces an input impedance variation, which can result in significant and undesired variations of a spectral shape of the TIA transfer function across ZT settings. It is desirable to have a variable-gain FE-TIA, which maintains performance metrics, such as bandwidth (BW) and group delay variation (GDV), approximately constant when the transimpedance ZT varies within a target operating range thereof.

For low values of the feedback resistance R_{F}, variations of the TIA input impedance Z_{IN} can also compromise the TIA stability. To obviate this problem, one solution is to also vary the voltage gain A₀ of the core amplifier 212 proportionally to the R_{F}. However, this comes with several implementation issues. Firstly, the A₀ variation can worsen the amplifier gain-bandwidth product (GBW), which may be undesirable, e.g. for high-speed TIAs. The voltage gain variation can also produce significant penalties of the amplifier GDV and linearity.

For example, the voltage gain A₀ may be controlled by tuning a load resistor of the core amplifier 212 (not shown in FIG. 2), e.g. by placing a MOS transistor in parallel with a fixed resistor. However, if the desired dynamic range of the voltage gain A₀ is large (e.g. ~>12dB), a large MOS transistor is required, and its capacitive parasitics may significantly limit the amplifier BW.

In BiCMOS technology, if the input differential pair is realized with bipolar transistors, the amplifier gain A₀ is directly proportional to the DC current of the input stage, so the bias current can be used to linearly control the A₀. However, input-stage current reduction may result in a significant noise and linearity penalty at low gain, as well as large and undesired variations of the amplifier output DC bias.

Another possible TIA implementation may use a resistively-degenerated amplifier topology, with a variable degeneration resistor. However, this poses limitations for ultrahigh speed TIAs. Ideally the variable resistor should be able to reach very low values when the TIA is set to maximum gain, to maximize GBW. However this may dictate the use of large MOS transistors, whose capacitive parasitics create undesired peaking in the transfer function at maximum gain. As a result, this technique may result in either GBW reduction or peaking.

Another way to vary the TIA voltage gain A₀ is to use a current-steering topology. However, there may be requirements for a significant gain reduction through current steering (>6dB), which may result in a linearity limitation from the amplifier. Additionally, current steering with high dynamic range may also result in large noise penalty and output DC bias variations.

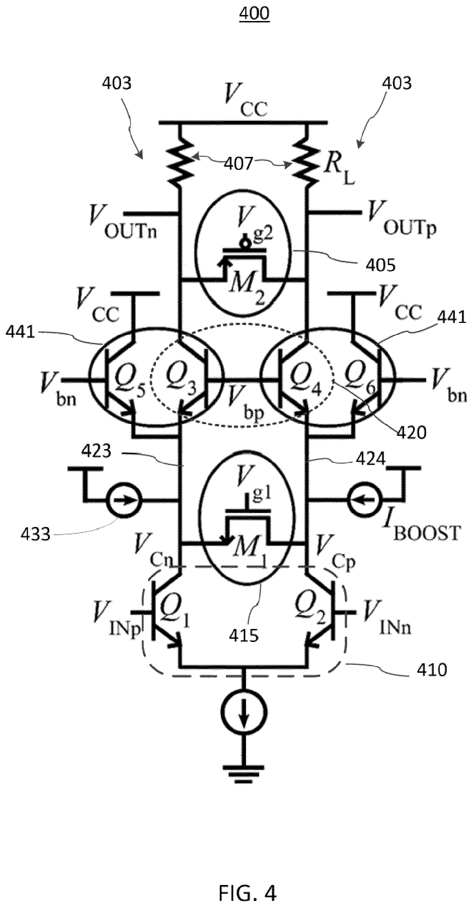

FIG. 4 illustrates an example circuit diagram of a voltage amplification stage 400 of a FE-TIA circuit according to an embodiment of the present disclosure. The voltage amplification stage 400 may be used, e.g., as the core amplifier 212 of the FE-TIA 210 of FIG. 3, and may also be referred herein as a core gain stage 400 or a core amplifier 400. In the circuit illustrated in FIG. 4 the voltage gain may be varied in three steps using three different tuning elements or sub-circuits, each tuning element or sub-circuit configured to vary the gain across only a fraction of the overall gain variation rage of the FE-TIA, so that the impact of gain variations on the TIA performance may be lessened. In the illustrated embodiment, the core amplifier 400 is based on a cascode topology, e.g. as typically used in BiCMOS high-speed amplifiers. This topology combines an input common-emitter or differential pair stage 410 (transistors Q₁/Q₂ in FIG. 4) with a common-base stage 420 (transistors Q₃/Q₄) to form a (differential) cascode circuit 403. Nodes 424, 423 (voltages V_{Cp} and V_{Cn} ), i.e. the emitters of the transistors Q₃, Q₄ of the cascode common-base stage 420, are referred to herein as "cascode nodes".

For a first gain control step, a tunable resistor element 405, e.g. a transistor M₂, e.g. a MOSFET controlled by a gate voltage V_{g2}, is placed in parallel with the load resistor R_{L} 407 and is configured to variably reduce the voltage gain A₀ of the core amplifier 400, e.g. up to about 6dB. The tunable resistor element 405 may also be referred to herein as the load shunt. When sized for only 6dB gain reduction, the transistor M₂ can be made small enough that it contributes negligibly to the BW reduction compared to other capacitive parasitics at the output node. On the other hand, reducing the load impedance by half improves the core amplifier BW at medium/low gain, which improves the TIA stability and GDV.

Another tunable resistor element 415, e.g. a transistor M₁ controlled by a gate voltage V_{g1}, e.g. also a MOSFET, is introduced to shunt the cascode node(s) 423, 424 and reduce the voltage gain A₀ further, e.g. between about 6 and 12dB. In an embodiment the tunable resistor element 415 ("cascode shunt") reduces the impedance of the cascode node(s) 423, 424 by up to a factor of 2, to about one half of the original value, which improves the TIA input linear range at moderate/low gains. Indeed, if, for example, the core amplifier 400 employs gm-boosting to maximize GBW, i.e. the cascode circuit 403 includes current sources I_{BOOST} 433 providing additional current to the cascode node(s) 423, 424, as shown in FIG. 4, circuit simulations show that compression at the cascode node(s) 423, 424 is likely to be a main source of nonlinearity. A reduction of the cascode node impedance by significantly more than a factor of two, e.g. to about a quarter of the original value or less, could result in a significant input impedance variation via a Miller effect, with impact on stability and peaking, as well as requiring a larger size for the transistor M₁, undesirably impacting the amplifier BW. Advantageously, limiting the voltage gain A₀ reduction via cascode node shunting to less than 12dB typically, e.g. to 10 dB or less, or 8dB or less, or 6dB or less in some example embodiments, allows the FE-TIA (e.g. the FE-TIA 210 of FIG. 3, when using the voltage amplification stage 400 in the core amplifier 212) to remain within an approximately linear regime with a suitably low impact on the spectral shape of the transfer function, e.g. as defined by application requirements. The cascode shunt 415 implemented with the transistor M₁ and the load shunt 405 implemented with the transistor M₂ may each also be referred to as an AC shunt, as there may typically be little, if any, DC current flowing through the transistors M₁ and M₂ in operation. The cascode shunt 415 implemented with the transistor M₁ may also be referred to as an internal AC shunt 415, as it shunts internal nodes, e.g. nodes between two gain stages 410 and 420, of the voltage amplification stage 400.

The remaining gain reduction, e.g. from about 12dB to about 24dB, is performed by current steering circuits 441 through bipolar transistors Q₅ and Q₆. The gain control at this current steering circuit 441 is performed by setting base voltages V_{bp} and V_{bn} of the transistors Q₃/Q₄ and Q₅/Q₆ respectively, such that a variable part of the signal current, i.e. of the AC current produced by the differential pair of transistors Q₁ and Q₂, is steered away from the load and into "dummy" paths via the transistors Q₅ and Q₆. Limiting the amount of voltage gain reduction due to the current steering to about 12dB seems to cause a near minimal reduction of linearity and to also limit noise degradation to acceptable levels, as well as enabling a manageable output DC bias variation.

The three voltage gain (A₀) variation techniques described above may be used sequentially, e.g. in the order described above, together with a proportional variation of the shunt resistor R_{F} (not shown in FIG. 4), to realize a TIA with up to 24dB ZT variation with a reduced impact on noise, GDV, linearity and BW.

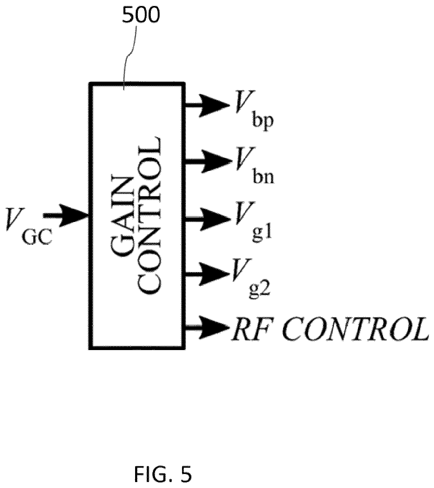

Referring to FIG. 5, this may be achieved e.g. by implementing a gain control circuit 500 which takes one single control voltage Vcc as an input, and generates voltages V_{g1} (to control cascode node shunting by M1), V_{g2} (to control load node shunting by M₂), V_{bp} and V_{bn} (to control current steering), as well as an R_{F} variation control signal.

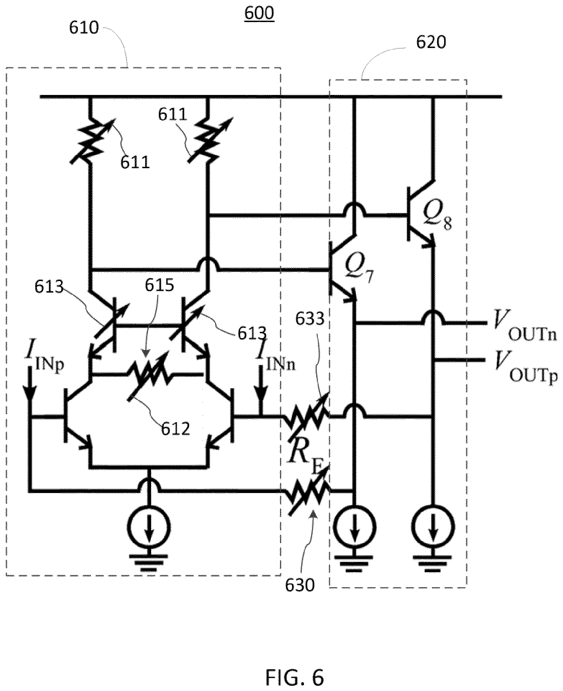

FIG. 6 illustrates a circuit schematic of an example FE-TIA 600 with the three-stage gain control described above with reference to FIG. 4. The FE-TIA 600 includes a variable-gain stage 610 that connects to a differential emitter follower 620, implemented with transistors Q₇ and Q₈, via variable feedback resistor(s) R_{F} 630. The variable-gain stage 610 may be embodied, e.g. with the core gain stage 400 shown in FIG. 4. Gm boosting current sources 433 of FIG. 4, as well as current steering transistors Q₅/Q₆, and variable AC shunt elements 405 and 415 of FIG. 4, are not shown in FIG. 6 in order not to obscure the schematic. The arrows 611, 612, 613 crossing variable circuit elements of the variable-gain stage 610 indicate the three tuning mechanisms shown in FIG. 4, which may be activated in the same order as. E.g., the variable cascode shunt 415 of FIG. 4 is represented in FIG. 6 as a variable resistor 615 ("first tuning element") connecting the cascode nodes. The arrow 633 crossing the feedback resistor 630 indicate the R_{F} tuning.

According to an example embodiment disclosed above, e.g., in the summary section and/or in reference to any one or any combination of some or all of FIGs. 1 - 6, provided is an apparatus (e.g. 100, FIG. 1; 200, FIG. 2; 300, FIG. 3), comprising a TIA circuit (e.g. 210, FIGs. 2, 3; 600, FIG. 6). The TIA circuit comprises a cascode circuit (e.g. 403, FIG. 4; 610, FIG. 6) including a cascode node (e.g. 423, 424, FIG. 4), and a first tunable element (e.g. 415, FIG. 4; 615, FIG. 6) connected to tunably shunt the cascode node to vary a voltage gain of the TIA circuit.

The example embodiment described above is not intended to be limiting, and many variations will become apparent to a skilled reader having the benefit of the present disclosure. For example, in some embodiments only the cascode shunting stage (M1) (an internal AC shunt) may be present. In another example only two of the proposed gain tuning techniques may be used. In another example, current sources I_{BOOST} may not be employed, and/or the input differential pair Q₁/Q₂ may be resistively degenerated. In another example, the emitter followers 620 shown in FIG. 3 might not be used, or multiple emitter followers might be employed. In another example, the order of the tuning of the shunting and current steering stages may be different from described. In another example, although in FIG. 4 transistors Q₁ to Q₆ are shown as bipolar transistors, some or all of the transistors Q₁ to Q₆ may be implemented with suitable FETs. Furthermore, although the example embodiment illustrated in FIG. 2 has a differential input to differential output configuration, other embodiments may have single input to differential output configuration, single input to single output (SISO) configuration, or a differential input to single output configuration. In SISO amplifier embodiments, cascode node shunting (internal AC shunt) may be implemented e.g with a MOSFET, such as M₁ connected to a source of DC voltage to equalize DC voltages on the source and drain terminals of the MOSFET.

Thus it will be understood by one skilled in the art that various changes in detail may be affected in the described embodiment without departing from the spirit and scope of the invention as defined by the claims.

## Claims

1. An apparatus, comprising:
a TIA circuit (130; 200; 600) comprising a variable-gain amplifier (VGA) (400; 610) having a tunable internal AC shunt (415; 615).

2. The apparatus of claim 1 wherein the VGA comprises:
a cascode circuit (403) including a cascode node (423, 424); and
the tunable internal AC shunt comprises a first tunable element (M₁) connected to variably shunt the cascode node.

3. The apparatus of claim 2 wherein the first tunable element comprises a first transistor (M₁) operable to vary an impedance of the cascode node by at most 6 dB.

4. The apparatus of claim 2 wherein the first tunable element comprises a first transistor (M₁) operable to vary an impedance of the cascode node by at most 12 dB.

5. The apparatus of any one of claims 2 to 4, wherein the first tunable element is a MOS transistor.

6. The apparatus of any one of claims 2 to 5 further comprising a second tunable element (405) connected to shunt a load resistor (407) of the TIA circuit.

7. The apparatus of claim 6 wherein each of the first and second tunable elements are configured to reduce the voltage gain of the TIA circuit by no more than 12dB.

8. The apparatus of any one of claims 1 to 7 further comprising a current steering circuit (441).

9. The apparatus of any one of claims 1 to 8 comprising a coherent optical receiver (100) including a balanced photodetector pair (120) connected to the TIA circuit.

10. A method for controlling a TIA gain, comprising:
a) variably shunting a cascode node (423, 424) of the TIA.

11. The method of claim 10, further comprising at least one of:
b) variably shunting a load resistor (407) of the TIA; and
c) steering a tunable fraction of a current flowing through the cascode node away from the load resistor.

12. The method of claim 11 wherein the variably shunting a load resistor of the TIA decreases the TIA gain by a first amount, and wherein at least one of the variably shunting a cascode node of the TIA and the steering a tunable fraction of a current flowing through the cascode node away from the load resistor further decreases the TIA gain by a second amount additional to the first amount.

13. The method of claim 12 wherein the variably shunting a cascode node of the TIA decreases the TIA gain by the second amount additionally to the first amount, and the steering a tunable fraction of a current flowing through the cascode node away from the load resistor further decreases the TIA gain by a third amount additional to the first and second amounts.
